# EUROPÄISCHE PATENTSCHRIFT

(11) **EP 4 186 094 B1**
(45) Veröffentlichungstag und Bekanntmachung des Hinweises auf die Patenterteilung: **19.11.2025**
(21) Anmeldenummer: 21769067.6
(22) Anmeldetag: 19.08.2021
(51) Int. Cl.: H01L 23/367, H01L 23/467, H01L 25/07, H01L 25/18

(54) **ANORDNUNG ZUR KÜHLUNG UND MOTORMODUL**
COOLING ARRANGEMENT AND MOTOR MODULE
AGENCEMENT DE REFROIDISSEMENT ET MODULE DE MOTEUR

(30) Priorität: 21.10.2020 EP 20202967
(43) Veröffentlichungstag der Anmeldung: 31.05.2023
(73) Patentinhaber: Siemens Aktiengesellschaft, 80333 München (DE)
(72) Erfinder: NAMYSLO, Lutz, 91353 Hausen (DE); KÖGLER, Roman, 90403 Nürnberg (DE); SCHWINN, Thomas, 91074 Herzogenaurach (DE)
(74) Vertreter: Siemens Patent Attorneys
(86) Internationale Anmeldenummer: PCT/EP2021/073019
(87) Internationale Veröffentlichungsnummer: WO 2022/083919

(56) Entgegenhaltungen:
- CN-A- 107 481 981
- US-A- 5 421 406
- US-A1- 2017 170 097

## Beschreibung

Die Erfindung betrifft eine Anordnung zur Kühlung von Halbleiter-Bauelementen umfassend eine Kühlkörper-Basis mit einer Bauelemente-Seite und eine der Bauelemente-Seite gegenüberliegenden Struktur-Element-Seite, wobei die Halbleiter-Bauelemente in Strömungsrichtung eines Kühlmediums hintereinander anordbar sind, wobei die Struktur-Element-Seite zur Vergrößerung ihrer Oberfläche mit Struktur-Elementen ausgestaltet ist.

Des Weiteren betrifft die Erfindung einen Stromrichter zur Ansteuerung eines Motors, insbesondere einen Umrichter.

Aus der Praxis ist es bekannt und üblich, zur Kühlung von Halbleiter-Bauelementen, Kühlkörper einzusetzen. Aus der EP 0 340 520 B1 ist eine Anordnung zur konvektiven Kühlung von Bauelementen bekannt, die einen Kühlkörper aufweist, der aus zwei übereinander angeordneten Teilen zusammengesetzt ist.

Aus der CN 107 481 981 A und der US 2017/170097 A1 sind Kühlanordnungen, bei denen eine Dichte an Kühlelementen in Strömungsrichtung zunimmt, bekannt.

Aus fertigungstechnischen Gründen und aufgrund eines einfacheren konstruktiven Aufbaus und/oder einer platzsparenden Anordnung von Halbleiter -Bauelementen, beispielsweise in Motor-Modulen, werden die Halbleiter-Bauelemente, welche zur Ansteuerung eines Motors benötigt werden, oft auf einem gemeinsamen Kühlkörper zur Entwärmung angeordnet. Diese Halbleiter-Bauelemente sind in Bezug auf eine Richtung eines Kühlmedium-Flusses nacheinander platziert, wodurch eine thermische Reihenschaltung entsteht. Diese thermische Reihenschaltung führt zu einer abnehmenden Kühlwirkung je weiter das jeweilige zu kühlende Halbleiter-Bauelement von einem Einlass des Kühlmediums entfernt ist.

Es ist Aufgabe der Erfindung eine Anordnung zur Kühlung von Halbleiter-Bauelementen bereitzustellen, bei welcher ein Kühlmedium auch bei weiter von einem Einlass entfernt liegenden zu kühlenden Bauteilen noch eine ausreichende Temperatur hat um damit eine Kühlleistung für das vom Einlass weiter entfernten Bauteil zu erbringen.

Für die eingangs genannte Anordnung wird die Aufgabe dadurch gelöst, dass die Struktur-Element-Seite eine gleichmäßige Verteilung an Struktur-Elementen aufweist, wobei die auf der Struktur-Elemente-Seite angeordneten Formteile zur Wärmeisolierung zumindest eines Teils der Struktur-Elemente vorgesehen sind.

Die Struktur-Elemente sind da, um die Wärmeübertragung an die Umgebung und damit die Kühlung zu verbessern. Die Struktur-Elemente stehen in der Regel in Kontakt mit einem Kühlmedium. Da nun die Dichte der aktiv an der Kühlung beteiligten Struktur-Elemente in Richtung einer Längsausdehnung der Anordnung zunimmt, können weiter entfernt von einem Einlass liegende Bauteile noch ausreichend gekühlt werden, da das Kühlmedium nicht schon bei einem ersten Bauteil, welches näher an einem Einlass liegt, in Bezug auf eine Kühlleistung gesättigt ist und somit keine Kühlleistung mehr erbringen kann.

Im Sinne der Erfindung ist unter Dichte die Anzahl von aktiven, wobei aktiv in Bezug auf eine Kühlwirkung zu sehen ist, Struktur-Elementen pro Flächeneinheit, insbesondere in den Kühlzonen, zu verstehen.

Die Formteile können in einer möglichen Ausführungsform als Hülsen über Pin-Fins gesteckt werden. Bei einem handelsüblichen Kühlkörper mit Pin-Fins hat man entsprechend eine gleichmäßige Verteilung der Struktur-Elemente, wobei ein Pin als ein Struktur-Element erachtet wird.

Eine derartige isolierende Hülse kann an ihrem einen Ende geschlossen und an ihrem anderen Ende offen sein. Vorteilhafter Weise werden die Hülsen in dem Bereich des Kühlkörpers angebracht, in dem die Wärmeabgabe an das Kühlmedium weitgehend unterbunden werden soll, **d.h.,** innerhalb einer ersten Kühlzone, welche in der Nähe eines Einlasses des Kühlmediums liegt. Die mit einer Hülse versehenen Pin-Fins werden damit thermisch quasi "ausgeschaltet". Somit gelangt mehr Kühlmedium mit einer geringeren Temperatur in dem vom Einlass weiter entfernt liegenden Bereich und erhöht dort die Kühlleistung.

Wie bereits erwähnt, kann ein Formteil als eine Hülse ausgestaltet sein und über ein Struktur-Element geschoben werden. Damit erhält man eine Anordnung, bei welcher zumindest ein Formteil als eine Hülse ausgestaltet ist und über ein Struktur-Element angeordnet ist.

Bei einer anderen Ausgestaltung eines Formteils ist die Anordnung derart ausgestaltet, dass zumindest ein Formteil als eine erste Art von Strömungs-Schranke ausgestaltet ist und über ein Struktur-Element geschoben ist, wobei ein erster Flügel der ersten Art von Strömungs-Schranke an ein weiteres direkt benachbartes Struktur-Element anliegt und ein zweiter Flügel der ersten Art von Strömungs-Schranke an ein anderes direkt benachbartes Struktur-Element anliegt.

Eine dritte Ausgestaltungsvariante eines Formteils sieht vor, dass bei der Anordnung zumindest ein Formteil mittels einer zweiten Art von Strömungs-Schranke ausgestaltet ist und über ein Struktur-Element geschoben ist, wobei ein erster Flügel der zweiten Art von Strömungs-Schranke an ein weiteres benachbartes Struktur-Element anliegt und ein zweiter Flügel der zweiten Art von Strömungs-Schranke an ein anderes benachbartes Struktur-Element anliegt, wobei die Flügel eine Längenausdehnung aufweisen, welche nur eine Anordnung der zweiten Art von Strömungs-Schranke schräg zur Strömungsrichtung zulassen.

Bei einer weiteren besonderen Ausgestaltungsvariante eines Formteils weist die Anordnung zumindest ein Formteil auf, welches als ein Medium-Leitband ausgestaltet ist, um eine gezielte Führung des Kühlmediums zu erreichen.

Die eingangs genannte Aufgabe wird ebenfalls durch einen eingangs genannten Stromrichter mit der zuvor beschriebenen Anordnung zur Kühlung gelöst.

Unter anderem ist es nun von Vorteil, dass man auf eine komplexe Bearbeitung eines Kühlkörpers verzichten kann, denn nun können z.B. Standard-Kühlkörper oder Kühlkörper mit einer gleichmäßigen Verteilung an Struktur-Elementen eingesetzt werden und durch gezieltes Einarbeiten von Formteilen, insbesondere in die Kühlzonen, an die entsprechenden Kühlbedingungen angepasst werden. Die gewünschte Wärmeverteilung wird durch die zusätzlichen Formteile, die nachträglich, z.B. insbesondere erst bei der Fertigung des Endproduktes, z.B. eines Antriebsumrichters, eingebracht werden, erzielt. Je nach Anwendungsfall sind auch unterschiedliche Formteile bei identischen Kühlkörpern denkbar. Eine Varianzbildung kann dann zum Vorteil der Herstellungskosten sehr spät in einem Produktionsprozess erst festgelegt werden, womit eine Lagerhaltung als auch eine Ersatzteilhaltung vereinfacht wird.

Insbesondere bei der Verwendung von modularen Kühlkörpern bzw. Anordnungen zur Kühlung von Halbleiter-Bauelementen können diese die Einzelteile nahezu identisch ausgeführt werden, wodurch eine Varianz im Produktionsprozess und in der Lagerhaltung mit Vorteil minimiert wird.

Der Stromrichter ist vorteilhaft vorgesehen, zum senkrechten Einbau in einen Schaltschrank, wobei eine Längsachse der Anordnung vertikal angeordnet ist und damit die Strömungsrichtung durch den Stromrichter parallel zur Längsachse entsteht und ein Einlass für ein Kühlmedium unten und ein Auslass für das Kühlmedium oben angeordnet ist.

Mit Vorteil kann man ein Motor-Modul aufbauen für mehrere Leistungshalbleiter, wobei eine erste Anordnung und eine weitere im Wesentlichen identische Anordnung hintereinander in Strömungsrichtung angeordnet sind.

Die Zeichnung zeigt ein Ausführungsbeispiel der Erfindung. Dabei zeigen
- FIG 1: eine perspektivische Ansicht einer Anordnung zur Kühlung,
- FIG 2: die aus FIG 1 bekannte Anordnung in einer anderen perspektivischen Ansicht,
- FIG 3: ein Formteil in der Ausgestaltung einer Hülse,
- FIG 4: ein Formteil in der Ausgestaltung einer ersten Art einer Strömung-Schranke,
- FIG 5: eine Ausgestaltung eines Formteiles in einer zweiten Art einer Strömungs-Schranke,
- FIG 6: eine Ausgestaltung eines Formteiles als ein Medium-Leitband,
- FIG 7: einen Pin-Fin-Kühlkörper mit gesteckten Formteilen,
- FIG 8: zwei hintereinander angeordnete Anordnungen mit Gruppenbildung von Halbleiter-Bauelementen und
- FIG 9: ein Motor-Modul in einem Schaltschrank.

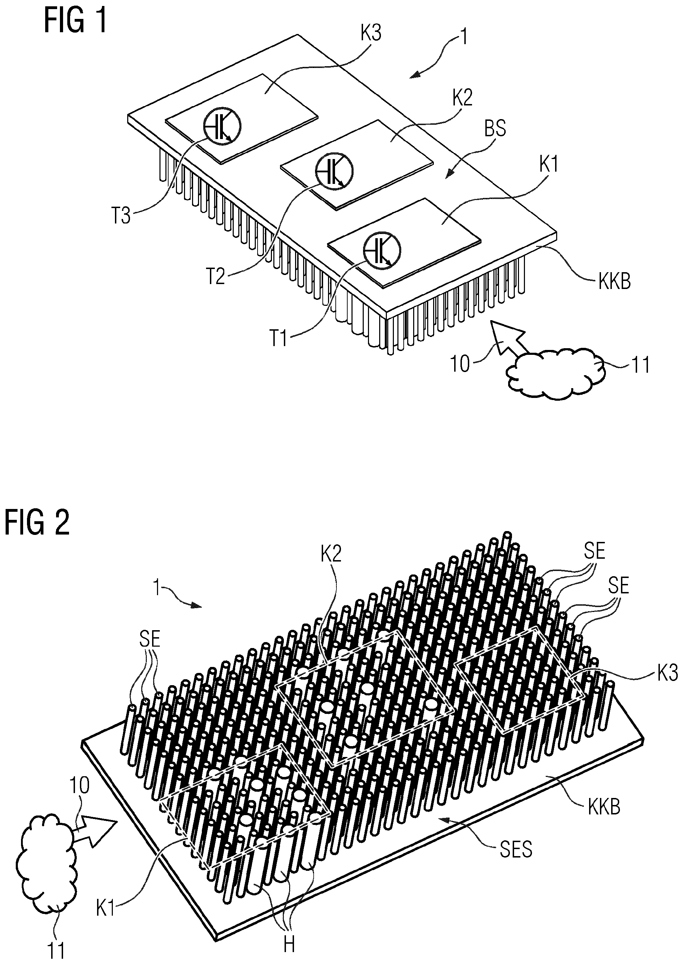

FIG 1 zeigt eine Anordnung 1 zur Kühlung von Halbleiter-Bauelementen T1,T2,T3 die auf einer Bauelement-Seite BS einer gemeinsamen Kühlkörper-Basis KKB in Strömungsrichtung 10 eines Kühlmediums 11 hintereinander angeordnet sind. Die Bauelemente-Seite BS weist für die Platzierung der Halbleiter-Bauelemente T1,T2,T3 eine erste Kühlzone K1, eine zweite Kühlzone K2 und eine dritte Kühlzone K3 auf.

Gemäß FIG 2 ist die perspektivische Darstellung auf die Struktur-Element-Seite SES gewählt. Auf der Struktur-Element-Seite SES sind zahlreiche Struktur-Elemente SE angeordnet. Die mit FIG 1 aufgezeigten Kühlzonen K1,K2,K3 sind in der Ansicht von FIG 2 schematisch gestrichelt dargestellt.

Die Struktur-Element-Seite SES weist eine gleichmäßige Verteilung von Struktur-Elementen SE auf, wobei durch die Anordnung von wärmeisolierenden Formteilen zwischen und/oder über einen Teil der Struktur-Elemente SE, dieser Teil an Struktur-Elementen SE inaktiv in Bezug auf eine Kühlwirkung wird. Da die erste Kühlzone K1 in der Nähe eines Einlasses für das Kühlmedium 11 liegt, können hier mehrere Formteile in Form von Hülsen H gesteckt werden, so dass sich das durchströmende Kühlmedium 11 nicht so schnell aufheizt und noch ausreichend Kühlleistung für die dahinterliegende zweite Kühlzone K2 und dritte Kühlzone K3 bringen kann.

Demnach sind in der ersten Kühlzone K1 neun Hülsen H gesteckt, in der zweiten Kühlzone K2 sind nur noch sieben Hülsen H gesteckt und in der dritten Kühlzone K3 ist gar keine Hülse H mehr gesteckt. Damit nimmt die Dichte von an der Kühlung beteiligten Struktur-Elementen SE bezogen auf die Kühlzonen K1,K2,K3 zu.

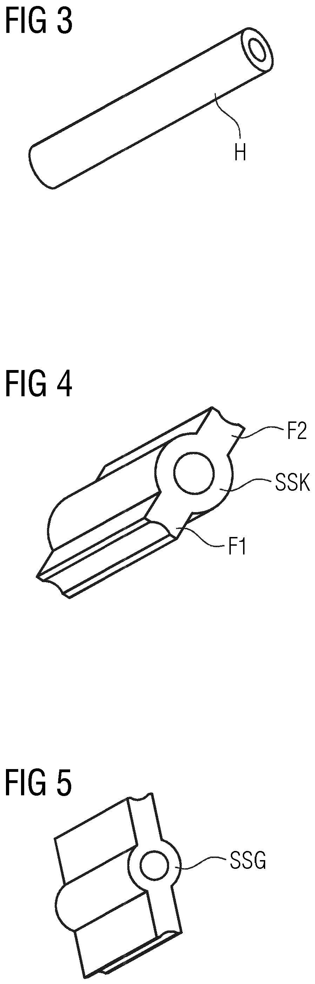

Die FIG 3 zeigt in einer ersten Ausgestaltungsvariante eines Formteils eine Hülse H mit einem Sackloch, welches ausgestaltet ist, um genau über einen Pin (nämlich dem Struktur-Element SE) gesteckt zu werden.

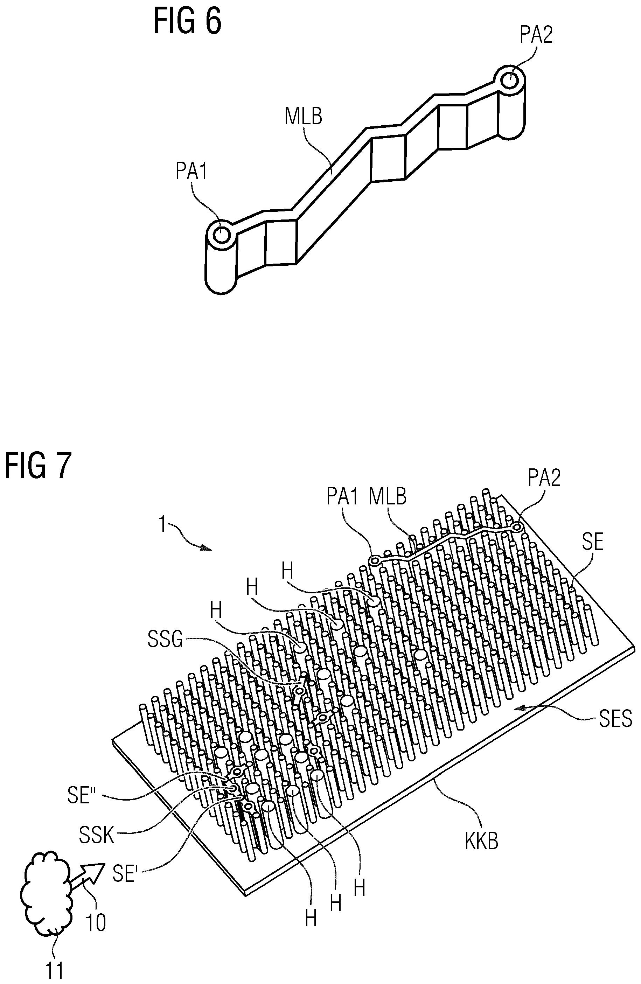

Mit der FIG 4 ist eine Ausgestaltungsvariante des Formteils als eine erste Art von Strömungs-Schranke SSK gezeigt. Diese erste Art von Strömungs-Schranke SSK kann ebenfalls über ein Struktur-Element SE geschoben werden. Zusätzlich weist die erste Art von Strömungs-Schranke SSK einen ersten Flügel F1 und einen zweiten Flügel F2 auf. Der erste Flügel F1 und der zweite Flügel F2 sind derart ausgestaltet, dass die Flügel F1,F2 jeweils an ein erstes benachbartes Struktur-Element SE' und an ein zweites benachbartes weiteres Struktur-Element SE" (siehe beispielsweise FIG 7) formschlüssig anliegen können.

Im Gegensatz zu FIG 4, wo die erste Art von Strömungs-Schranke SSK dargestellt wurde, wird in FIG 5 eine etwas größere zweite Art von Strömungs-Schranke SSK dargestellt. Auch die zweite Art der Strömungs-Schranke SSG ist ausgestaltet um über ein Struktur-Element SE geschoben werden zu können, wobei der erste Flügel F1 der zweiten Art von Strömungs-Schranke SSK an ein weiteres benachbartes Struktur-Element SE und ein zweiter Flügel F2 der zweiten Art von Strömungs-Schranke SSG auch an ein benachbartes Struktur-Element SE anliegen kann. Aber die Längenausdehnung der Flügel F1,F2 im Gegensatz zu der ersten Art von Strömungs-Schranke SSK ist bei der zweiten Art von Strömungs-Schranke SSG so lang, dass diese Art von Formteil nur schräg zur Strömungsrichtung 10 zwischen den Struktur-Elementen SE angeordnet werden kann.

Eine weitere besondere Art an Formteil wird gemäß FIG 6 aufgezeigt. Das Formteil ist nun als ein Medium-Leitband MLB ausgestaltet, um eine gezielte Führung des Kühlmediums zu erreichen. Dazu weist das Medium-Leitband MLB eine Längenausdehnung auf, welche sich über eine Vielzahl von Abständen von Struktur-Elementen SE erstreckt. An einem ersten Ende des Medium-Leitbandes MLB ist eine erste Pin-Aufnahme PA1 angeordnet und an einem zweiten Ende des Medium-Leitbandes MLB ist eine zweite Pin-Aufnahme PA2 angeordnet. Da das Medium-Leitband MLB hitzebeständig und flexibel ausgestaltet ist, kann man mit einem Medium-Leitband MLB einen Strömungs-Kanal beeinflussen, weil man es auf einfache Art und Weise wie ein Gummiband zwischen die Struktur-Elemente SE stecken kann. Mit der FIG 7 ist eine mit den zuvor genannten Ausführungsvarianten der Formteile bestückte Kühlanordnung beispielsweise aufgezeigt. Im unteren Teil an einem Einlass für ein Kühlmedium 11 sind beispielsweise mehrere Hülsen H und mehrere erste Art von Strömungs-Schranken SSK gesetzt. Kommt man näher an die zweite Kühlzone K2 so wird kurz vor der zweiten Kühlzone K2 eine zweite Art von Strömungs-Schranken SSG zur Strömungs-Führung in die zweite Kühlzone K2 eingesetzt. Damit der bereits abgelenkte Kühlmediums-Strom durch die zweite Kühlzone K2 nicht gänzlich aus den Struktur-Elementen SE entweicht und noch die dritte Kühlzone K3 erreicht, wird wie eine Art Spoiler durch ein Medium-Leitband MLB eingesetzt und der ursprünglich ausgelenkte Kühlstrom wieder in eine andere Richtung abgelenkt.

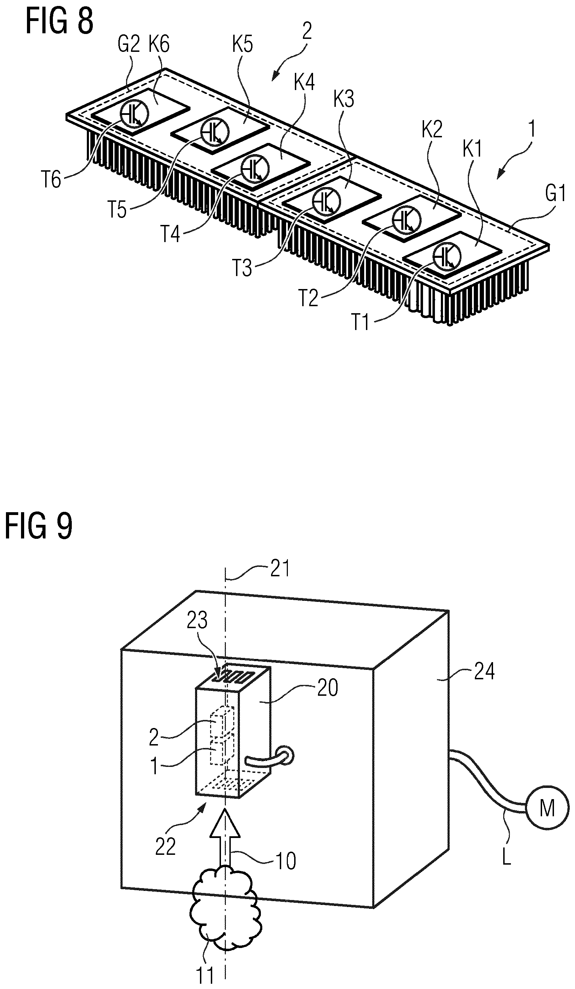

Mit der FIG 8 wird verdeutlicht, wie die erste Anordnung 1 zur Kühlung von Halbleiter-Bauelementen durch eine weitere zweite Anordnung 2 zur Kühlung von Halbleiter-Bauelementen modular ergänzt werden kann. Es kann beispielsweise bei einem Stromrichter 20 (siehe FIG 9) vorkommen, dass dieser ausgestaltet ist, als ein 2-Achs-Umrichter, welcher gleichzeitig zwei Motoren steuern kann. Dementsprechend hat man eine modular zusammengesetzte Anordnung aus der ersten Anordnung 1 und der zweiten Anordnung 2, wobei eine erste Gruppe G1 von zu kühlenden Halbleiter-Bauelementen T1, T2, T3 entsteht und eine zweite Gruppe G2 von zu kühlenden Halbleiter-Bauelementen T4, T5, T6 entsteht.

In der ersten Gruppe G1 finden in den entsprechenden Kühlzonen K1,K2,K3 die entsprechenden Halbleiter-Bauelemente T1,T2,T3 Platz. In der zweiten Gruppe G2 findet in einer vierten Kühlzone K4, einer fünften Kühlzone K5 und einer sechsten Kühlzone K6 entsprechend die weiteren Halbleiter-Bauelemente T4,T5,T6 Platz.

Gemäß FIG 9 ist ein Stromrichter 20 in einen Schaltschrank 24 dargestellt. Eine Längsachse 21 des Stromrichters 20 bzw. der innen integrierten Anordnung 1 ist vertikal angeordnet und damit ist die Strömungsrichtung 10 durch den Stromrichter 20 parallel zur Längsachse 21 und ein Einlass 22 für das Kühlmedium 11 ist unten angeordnet und ein Auslass 23 für das Kühlmedium 11 ist oben angeordnet. Bei dem Stromrichter 20 ist eine erste Anordnung 1 und eine zweite Anordnung 2 zur Kühlung der Bauelemente hintereinander in Strömungsrichtung 10 angeordnet. Insbesondere sind zur gleichmäßigen Temperaturverteilung auf beide Anordnungen 1,2 die erste, zweite, dritte Kühlzone K1,K2,K3 der ersten Anordnung 1 mit Formteilen bestückt, wobei die Anzahl an Formteilen in Strömungsrichtung abnimmt. Das Motor-Modul 20 kann über eine Leitung L, einen Motor M steuern.

## Patentansprüche

1. Anordnung (1) zur Kühlung von Halbleiter-Bauelementen (T1,T2,T3) umfassend eine Kühlkörper-Basis (KKB) mit einer Bauelemente-Seite (BS) und eine der Bauelemente-Seite (BS) gegenüberliegenden Struktur-Element-Seite (SES), wobei die Halbleiter-Bauelemente (T1,T2,T3) in Strömungsrichtung (10) eines Kühlmediums (11) hintereinander anordbar sind,
wobei die Struktur-Element-Seite (SES) zur Vergrößerung ihrer Oberfläche mit Struktur-Elementen (SE) ausgestaltet ist, wobei die Struktur-Element-Seite (SES) derart ausgestaltet ist, dass eine Dichte (D) von an der Kühlung beteiligten Struktur-Elementen (SE) bezogen auf Kühlzonen (K1,K2,K3) in Strömungsrichtung (10) zunimmt, **dadurch gekenn- zeichnet**, dass die Struktur-Element-Seite (SES) eine gleichmäßige Verteilung an Struktur-Elementen (SE) aufweist und wärmeisolierende Formteile aufweist, wobei die auf der Struktur-Elemente-Seite (SES) angeordneten Formteile zur Wärmeisolierung zumindest eines Teils der Struktur-Elemente (SE) vorgesehen sind.

2. Anordnung nach Anspruch 1, wobei zumindest ein Formteil als eine Hülse (H) ausgestaltet ist und über ein Struktur-Element (SE) geschoben ist.

3. Anordnung nach Anspruch 1 oder 2, wobei zumindest ein Formteil als eine erste Art von Strömungs-Schranke (SSK) ausgestaltet ist und über ein Struktur-Element (SE) geschoben ist, wobei ein erster Flügel (F1) der ersten Art von Strömungs-Schranke (SSK) an ein weiteres benachbartes Struktur-Element (SE') anliegt und ein zweiter Flügel (F1) der ersten Art von Strömungs-Schranke (SSK) an ein anderes direkt benachbartes Struktur-Element (SE'') anliegt.

4. Anordnung nach Anspruch 2 oder 3, wobei zumindest ein Formteil als eine zweite Art von Strömungs-Schranke (SSG) ausgestaltet ist und über ein Struktur-Element (SE) geschoben ist, wobei ein erster Flügel (F1) der zweiten Art von Strömungs-Schranke (SSK) an ein weiteres benachbartes Struktur-Element (SE') anliegt und ein zweiter Flügel (F1) der zweiten Art von Strömungs-Schranke (SSK) an ein anderes benachbartes Struktur-Element (SE'') anliegt, wobei die Flügel (F1,F2) eine Längenausdehnung aufweisen, welche nur eine Anordnung der zweiten Art von Strömungs-Schranke (SSG) schräg zur Strömungsrichtung (10) zulassen.

5. Anordnung nach einem der Ansprüche 1 bis 4, wobei zumindest ein Formteil als ein Medium-Leitband (MLB) ausgestaltet ist um eine gezielte Führung des Kühlmediums (11) zu erreichen.

6. Stromrichter (20) zur Ansteuerung eines Motors (M) umfassend eine Anordnung (1) nach einem der Ansprüche 1 bis 5.

7. Stromrichter (20) nach Anspruch 6, vorgesehen zum senkrechten Einbau in einen Schaltschrank (24), wobei eine Längsachse (21) der Anordnung (1) vertikal angeordnet ist und damit die Strömungsrichtung (10) durch den Stromrichter (20) parallel zur Längsachse (21) entsteht und ein Einlass (22) für ein Kühlmedium (11) unten und ein Auslass (23) für das Kühlmedium (11) oben angeordnet ist.

8. Stromrichter (20) nach einem der Ansprüche 6 oder 7, wobei eine erste Anordnung (1) und eine zweite identische, bezogen auf die Struktur-Element-Seite (SES), hintereinander in Strömumgsrichtung (10) angeordnet sind, wobei auf der zweiten Anordnung weniger Formteile angeordnet sind.

## Claims

1. Arrangement (1) for cooling semiconductor components (T1, T2, T3) comprising a cooling body base (KKB) with a component side (BS) and a structural element side (SES) opposite the component side (BS), wherein the semiconductor components (T1, T2, T3) can be arranged in succession in the flow direction (10) of a cooling medium (11),
wherein the structural element side (SES) is designed to enlarge its surface with structural elements (SE),
wherein the structural element side (SES) is designed such that a density (D) of structural elements (SE) involved in the cooling increases in the flow direction (10) with regard to cooling zones (K1, K2, K3), **characterised in that** the structural element side (SES) has a uniform distribution of structural elements (SE) and heat-insulating moulded parts, wherein the moulded parts arranged on the structural element side (SES) are provided to thermally insulate at least one part of the structural elements (SE).

2. Arrangement according to claim 1, wherein at least one moulded part is designed as a sleeve (H) and is slid over a structural element (SE).

3. Arrangement according to claim 1 or 2, wherein at least one moulded part is designed as a first type of flow barrier (SSK) and is slid over a structural element (SE), wherein a first limb (F1) of the first type of flow barrier (SSK) rests against a further adjacent structural element (SE') and a second limb (F1) of the first type of flow barrier (SSK) rests against another directly adjacent structural element (SE").

4. Arrangement according to claim 2 or 3, wherein at least one moulded part is designed as a second type of flow barrier (SSG) and is slid over a structural element (SE), wherein a first limb (F1) of the second type of flow barrier (SSK) rests against a further adjacent structural element (SE') and a second limb (F1) of the second type of flow barrier (SSK) rests against another adjacent structural element (SE''),
wherein the limbs (F1, F2) have a longitudinal extent which only permit an arrangement of the second type of flow barrier (SSG) obliquely to the flow direction (10).

5. Arrangement according to one of claims 1 to 4, wherein at least one moulded part is designed as a medium guide band (MLB) in order to achieve a targeted guidance of the cooling medium (11).

6. Converter (20) for controlling a motor (M) comprising an arrangement (1) according to one of claims 1 to 5.

7. Converter (20) according to claim 6, provided for vertical installation in a control cabinet (24), wherein a longitudinal axis (21) of the arrangement (1) is arranged vertically and thus the flow direction (10) through the converter (20) is produced parallel to the longitudinal axis (21) and an inlet (22) for a cooling medium (11) is arranged below and an outlet (23) for the cooling medium (11) is arranged above.

8. Converter (20) according to one of claims 6 or 7, wherein a first arrangement (1) and a second identical one are arranged in succession in the flow direction (10) with regard to the structural element side (SES), wherein fewer moulded parts are arranged on the second arrangement.

## Revendications

1. Agencement (1) de refroidissement de composants (T1, T2, T3) à semiconducteur comprenant une base-puits de chaleur (KKB) ayant une face composant (BS) et une face élément de structure (SES) opposée à la face composant (BS), dans lequel les composants (T1, T2, T3) à semiconducteur peuvent être disposés les uns derrière les autres dans le sens (10) d'écoulement d'un fluide (11) de refroidissement,
dans lequel la face élément de structure (SES) est, pour l'agrandissement de sa surface, conformée en ayant des éléments (SE) de structure, dans lequel la face élément de structure (SES) est conformée de manière à ce qu'une densité (D) d'éléments (SE) de structure faisant partie du refroidissement augmente dans le sens (10) d'écoulement, rapportée à des zones (K1, K2, K3) de refroidissement, **caractérisé en ce que** la face élément de structure (SES) a une répartition uniforme d'éléments (SE) de structure et a des pièces de forme isolantes thermiquement, dans lequel les pièces de forme disposées sur la face élément de structure (SES) sont prévues pour l'isolation thermique d'au moins une partie des éléments (SE) de structure.

2. Agencement suivant la revendication 1, dans lequel au moins une pièce de forme est constituée sous la forme d'un manchon (H) et est glissée sur un élément (SE) de structure.

3. Agencement suivant la revendication 1 ou 2, dans lequel au moins une pièce de forme est conformée sous la forme d'un premier type de barrière (SSK) à l'écoulement et est glissée sur un élément (SE) de structure, dans lequel une première aile (F1) du premier type de barrière (SSK) à l'écoulement s'applique à un autre élément (SE') de structure voisin et une deuxième aile (F1) du premier type de barrière (SSK) à l'écoulement s'applique à un autre élément (SE") de structure voisin directement.

4. Agencement suivant la revendication 2 ou 3, dans lequel au moins une pièce de forme est conformée sous la forme d'un deuxième type de barrière (SSG) à l'écoulement et est glissée sur un élément (SE) de structure, dans lequel une première aile (F1) du deuxième type de barrière (SSK) à l'écoulement s'applique à un autre élément (SE') de structure voisin et une deuxième aile (F1) du deuxième type de barrière (SSK) à l'écoulement s'applique à un autre élément (SE'') de structure voisin, dans lequel les ailes (F1, F2) ont une étendue en longueur, qui n'autorise une mise en place du deuxième type de barrière (SSG) à l'écoulement, que d'une manière inclinée par rapport au sens (10) d'écoulement.

5. Agencement suivant l'une des revendications 1 à 4, dans lequel au moins une pièce de forme est conformée sous la forme d'une bande conductrice de fluide (MLB) pour obtenir une conduite ciblée du fluide (11) de refroidissement.

6. Convertisseur (20) de commande d'un moteur (M) comprenant un agencement (1) suivant l'une des revendications 1 à **5.**

7. Convertisseur (20) suivant la revendication 6, prévu pour l'insertion perpendiculaire dans une armoire (24) de commande, dans lequel un axe (21) longitudinal de l'agencement (1) est disposé verticalement et ainsi le sens (10) d'écoulement dans le convertisseur (20) se crée parallèlement à l'axe (21) longitudinal et une entrée (22) d'un fluide (11) de refroidissement est disposée en bas et une sortie (23) du fluide (11) de refroidissement est disposée en haut.

8. Convertisseur (20) suivant l'une des revendications 6 ou 7, dans lequel un premier agencement (1) et un deuxième identique, rapportés à la face élément de structure (SES), sont disposés l'un derrière l'autre dans le sens (10) d'écoulement, dans lequel moins de pièces de forme sont disposées sur le deuxième agencement.
